Europäisches Patentamt

European Patent Office

Office européen des brevets

(11) Publication number : **0 508 722 A1**

# EUROPEAN PATENT APPLICATION

(21) Application number : **92303071.2**

(22) Date of filing : **07.04.92**

(51) Int. Cl.$^5$ : **H01B 1/22, C09J 9/02**

(30) Priority : **12.04.91 US 684606**
**12.11.91 US 791586**

(43) Date of publication of application :
**14.10.92 Bulletin 92/42**

(84) Designated Contracting States :
**DE GB NL**

(71) Applicant : **MINNESOTA MINING AND**
**MANUFACTURING COMPANY**
**3M Center, P.O. Box 33427**
**St. Paul, Minnesota 55133-3427 (US)**

(72) Inventor : **Calhoun, Clyde D., c/o Minnesota**
**Mining and**
**Manufact. Co., 2501 Hudson Road, P.O. Box**
**33427**
**St. Paul, Minnesota 55133-3427 (US)**
Inventor : **Berg, James G., c/o Minnesota**
**Mining and**
**Manufact. Co., 2501 Hudson Road, P.O. Box**
**33427**
**St. Paul, Minnesota 55133-3427 (US)**
Inventor : **Koskenmaki, David C., c/o**
**Minnesota Mining and**
**Manufact. Co., 2501 Hudson Road, P.O. Box**
**33427**
**St. Paul, Minnesota 55133-3427 (US)**
Inventor : **Swinehart, Robert M., c/o Minnesota**
**Mining and**
**Manufact. Co., 2501 Hudson Road, P.O. Box**
**33427**
**St. Paul, Minnesota 55133-3427 (US)**

(74) Representative : **Baillie, Iain Cameron et al**
**Ladas & Parry Altheimer Eck 2**
**W-8000 München 2 (DE)**

(54) **Electrically conductive adhesive tape.**

(57)   Electrically conductive adhesive tapes (10) comprising at least one carrier web (12) having a low-adhesion face bearing thereon an adhesive layer (18) having substantially uniform thickness and a Lap Shear Value from aluminum of at least 0.2 MPa, said tape being formed having a plurality of conductive particle (16) containing sections (14) selected from pockets and perforations, each section (14) containing a plurality of electrically conductive particles (16) in contact with the adhesive layer which is otherwise substantially free from electrically conductive material.

Fig.1

## Bakground of the Invention

### Field of the Invention

This invention relates to electrically conductive adhesive webs and to methods of making them. In one embodiment, the invention relates to such web where the adhesive is normally tacky and pressure-sensitive, preferably aggressively tacky.

### Description of the Related Art

Modern electrical devices are becoming so small that it is frequently virtually impossible to interconnect electrodes of two such devices either mechanically or by soldering. For many years there have been attempts to devise electrically conductive adhesives, and numerous U.S. patents have been issued of such products.

For example, U.S. Patent No. 3,347,978 discloses electrically conductive joints and gaskets where an adhesive containing a mass of electrically conductive fibers is used to bond two metal members.

In the field of pressure-sensitive adhesives, U.S. Patent No. 2,822,509 discloses an adhesive plaster having a conductive backing and an adhesive containing conductive particles. U.S. Patent 4,606,962 describes a pressure-sensitive adhesive layer incorporating conductive metal-coated particles, which are somewhat thicker than the adhesive layer. U.S. Patent No. 4,457,796 discloses a pressure-sensitive transfer adhesive containing chopped metal fibers to impart localized electrical conductivity.

Where it is important to have an adhesive that possesses both good electrical conductivity and good adhesion, most of the adhesive constructions discussed in the preceding paragraph have had serious problems. If a large quantity of conductive particles or fibers is blended with the adhesive, electrical conductivity is excellent, but adhesive properties are significantly reduced. Correspondingly, if a small quantity of conductive particles or fibers is used, adhesive properties are adequate, but the electrical conductivity is frequently too low to be acceptable. The problem is exacerbated where thick adhesive layers are required.

In a related nonadhesive development, U.S. Patent No. 4,008,300 discloses a foraminous elastomeric film in which the perforations are filled with a hardened electrically conductive slurry that bulges beyond both faces of the elastomer. A major disadvantage of this film is that mechanical clamping is still required in order to maintain the electrical connections. When clamped between flat surfaces, lateral forcible expansion of the individual rods puts them under pressure, thus assuring that each rod electrically interconnects facing pairs of electrical terminals on the flat surfaces.

In certain industries, e.g., manufacture of heavy appliances and the like, metal panels are typically spot welded or riveted together to form the enclosure for the appliance. While these methods of joining the panels provide both mechanical strength and electrical continuity, skilled operators are required and the inevitable disruption of the metal surface requires an additional abrading step to restore a smooth surface. It has long been recognized that an aggressive adhesive construction having excellent electrical properties would be more convenient to use, but no such construction has actually been available.

It has now been discovered that an electrically conductive adhesive tape having good electrical properties may be formed using a very small amount of conductive particles which are contained in perforations in the tape.

It has also been discovered that such a tape can be made without sacrificing adhesive properties such as peel and sheer.

### Summary of the Invention

The invention provides electrically conductive adhesive tapes comprising at least one carrier web having a low-adhesion face bearing thereon an adhesive layer having substantially uniform thickness and a Lap Shear Value from aluminum of at least 0.2 MPa.

The tape is formed having a plurality of conductive particle containing sections selected from perforations and pockets, each section containing a plurality of electrically conductive particles in contact with the adhesive layer which is otherwise substantially free from electrically conductive material. The carrier web may be permanently or releaseably attached thereto.

In one typical embodiment, the novel tape is formed with a plurality of equal sized pockets in an array, each containing a plurality of electrically conductive particles in contact with the nonconductive adhesive layer.

The adhesive layer can be separated from the carrier web to bond two substantially flat electrically conductive surfaces together, with particles of individual pockets or perforations bridging the adhesive layer to afford electrical interconnections between those surfaces.

The invention also provides foam tapes having aggressively tacky adhesives and good conductive properties.

The invention also provides a tape having conductive particles only in areas of the carrier web that correspond to electrodes to be interconnected.

As used herein, the term "carrier web", is used to mean a layer which is attached, releaseably or permanently to one or both sides of the adhesive layer. The terms "liner" and "release liner" are also used to indicate such webs, especially those which are releasably attached.

Detailed Description of the Invention

The invention provides an aggressively tacky pressure-sensitive adhesive tape containing electrically conductive particles by which multiple pairs of arrayed electrodes that are closely spaced can be reliably interconnected. The novel adhesive tape is more economical than comparable tapes of the prior art, because effective interconnections may be provided with extremely low total particle loadings. Adhesives may be selected to form bonds of the bonding strength required for a particular application.

The electrically conductive adhesive tape comprises at least one flexible carrier web that has a low-adhesion face bearing an adhesive layer thereon. The layer has a substantially uniform thickness and a Lap Shear Value from aluminum (measured under ASTM D1002) of at least about 0.2 MPa, preferably at least about 1 MPa.

The tape is formed with a plurality of conductive particle containing sections, either perforations or pockets, each containing a plurality of electrically conductive particles in contact with the adhesive layer which is otherwise substantially free of electrically conductive material. If desired, a tape may have both perforations and pockets.

When the novel tape is to be used to interconnect facing arrays of electrodes, the pockets or perforations preferably are of substantially equal size. Where pockets are used, there are preferably substantially equally sized small dimples. The sections, whether dimples or perforations can have a variety of shapes, e.g., hemispherical, pyramidal, conical or cylindrical. The conductive particle containing sections may be formed by mechanical punching, and laser drilling where the laser uses lenses that divide the laser beam into multiple beams, or by replication from a negative master. Exceedingly small and closely spaced pockets or dimples can also be formed in the low-adhesion face of the carrier web, e.g., by embossing. When the tape is used to interconnect closely spaced electrodes, each conductive particle containing section can be less than 0.1 mm in maximum breadth. In preferred tapes of the invention, the dimples or perforations are no greater than 0.05 mm in maximum breadth and are in an orderly predetermined pattern, such as a square, triangular or hexagonal array having center-to-center spacing no greater than 0.1 mm. The adhesive layer of such preferred tape can interconnect two facing arrays of electrodes having a lateral spacing as small as 0.1 mm without danger of short circuiting.

The conductive particle containing sections can be formed in the carrier web, in the adhesive layer or in both. Because the size and spacing of the dimples and/or perforations can be controlled to ensure good electrical interconnections, the particles can be used in such small amounts that they do not detract from the adhesive properties, i.e., peel and shear, of the adhesive. When desired, dimples and/or perforations can be formed only in those areas of the carrier web that correspond to electrodes to be interconnected. This reduces even further the amount of conductive particles necessary. Within those areas the perforations may be random, or may be arranged in any desired pattern. When perforations are so formed, the adhesive must be correctly oriented with respect to the electrode pairs prior to use. When the dimples or perforations are in an orderly array over the entire adhesive layer, there is no need to orient the adhesive layer. Also, when the adhesive layer is continuous and void-free between the electrodes, this seals the arrays against moisture and contamination.

After depositing electrically conductive particles into conductive particle containing sections formed in the carrier web and applying an adhesive layer, the adhesive layer can be pressed against one of a pair of arrays of electrodes. In doing so, the conductive particle containing sections keep substantially all of the particles in place, even when heat and pressure are applied to cause the adhesive to soften and flow laterally. After removing the carrier web, the exposed face of the adhesive layer can be pressed against the other array of electrodes. In doing so, the electrodes of the second array contact the particles before they contact the adhesive, so that the particles can be gripped between the facing electrode arrays before being subjected to lateral forces created by the pressing action. When the particles are so gripped, the flowing adhesive displaces few particles so that the proportion of particles in the adhesive layer directly between two facing electrodes can exceed its proportion in lateral spaces into which it has flowed. This affords the economy of reducing the number of unused particles.

Useful flexible carrier webs include film-forming polymers, including polyesters, polyolefins, polymethylmethacrylates, polyurethanes and the like, and papers having polymeric coatings. The adhesive may be permanently or releasably attached to the carrier web, and webs may be provided on only one or both sides of the adhesive tape, e.g., as in a transfer tape.

Useful electrically conductive particles includes metals such as silver or nickel, metal-coated polymeric particles and graphite. When the conductive particles are soft, as described in U.S. 4,606,962, Reylek, incorporated herein by reference, moderate hand pressure applied to interconnecting electrodes can flatten the particles to provide a small, flat conductive area where each particle contacts another particle or an electrode.

In preferred applications, the dimples and/or perforations should contain not only the electrically conductive particles, but an organic binder. The binder can bind the particles in each perforation into permanently coherent columns. When used, the binder typically contributes from about 1 to about 50% by volume of the total particles.

By selecting a binder that forms a strong bond to electrically conductive surfaces, the binder can supplement the bond created by the adhesive layer, thus improving adhesion, and reducing failures under adverse conditions.

Useful organic binders include rubber resins such as styrene-butadiene, and ABS copolymers, thermosetting resins such as epoxy resins and cyanate esters, and thermoplastic resins such as phenoxys, polysulfones, polyether sulfones and polyvinylacetyl resins. Preferred binders include mixtures of thermosetting and thermoplastic resins such as those disclosed in U.S. Pat. No. 4,769,399, (Schenz), incorporated herein by reference.

Preferred electrically conductive tapes of the invention contain a reworkable adhesive as either an adhesive layer, a binder or both, preferably provided as a nontacky or slightly tacky adhesive film, comprising the reaction product of: a) an effective amount of a thermoplastic polymer, having a $T_g$ of about 30°C to 250°C, and b) an effective amount of a crosslinkable resin.

The crosslinkable resin preferably comprises an epoxy resin or a cyanate ester resin. The epoxy resin preferably comprises an aromatic epoxy, and may also include an epoxy curative. The epoxy resin may typically comprise one or more components individually having a molecular weight of about 200 to 2000. The cyanate ester resin may typically include one or more components individually having a molecular weight of about 150 to 2000.

The thermoplastic polymer is preferably selected from the group consisting of polysulfones, polyvinyl acetals, polyamides, polyimides, polyesters, polyetherimides, polycarbonates, polyethers, and polyvinylics.

The cured adhesive composition has a shear strength of less than about 1 megaPascals ("MPa"), preferably less than about 0.5 MPa, at a temperature of about 20°C above the $T_g$ of the cured adhesive composition. The adhesive composition preferably has such a shear strength at the processing temperature, $T_p$, of the cured adhesive composition. $T_p$ is typically in the range of about 125°C to 250°C, and preferably in the range of about 150°C to 200°C.

The cured adhesive composition has a modulus of greater than about $1 \times 10^2$ MPa, preferably greater than about $1 \times 10^3$ MPa, at a temperature of about 20°C below the $T_g$ of the cured adhesive composition.

The adhesive useful in tapes of the invention may also be selected from thermoplastic and thermosetting adhesives, rubber resin adhesives, pressure-sensitive adhesives, and the like.

In one preferred embodiment, the adhesive is the same as the binder resin. This is especially preferred when the binder resin is a reworkable adhesive, as discussed, supra. In another preferred embodiment, the adhesive layer is a pressure-sensitive adhesive. The tape is then more convenient to apply, lacking a heating requirement. A preferred class of pressure-sensitive adhesives are acrylate adhesives. They can be monomers and/or oligomers such as (meth)acrylates (meth)acrylamides, vinyl pyrrolidone and azlactones, as disclosed in U.S. Pat. No. 4,304,705, (Heilmann). Such monomers include mono-, di-, or poly-acrylates and methacrylates.

Preferred acrylates are typically alkyl acrylates, preferably monofunctional unsaturated acrylate esters of non-tertiary alkyl alcohols, the alkyl groups of which have from 1 to 14 carbon atoms. Included with this class of monomers are, for example, isooctyl acrylate, isononyl acrylate, 2-ethyl-hexyl acrylate, decyl acrylate, dodecyl acrylate, n-butyl acrylate, and hexyl acrylate.

Preferred monomers include isooctyl acrylate, isononyl acrylate, 2-ethylhexyl acrylate, and butyl acrylate. The alkyl acrylate monomers can be used to form homopolymers or they can be copolymerized with polar copolymerizable monomers. When copolymerized with strongly polar monomers, the alkyl acrylate monomer generally comprises at least about 75% of the polymerizable monomer composition. When copolymerized with moderately polar monomers, the alkyl acrylate monomer generally comprises at least about 70% of the polymerizable monomer composition.

The polar copolymerizable monomers can be selected from strongly polar monomers such as monoolefinic mono- and dicarboxylic acids, hydroxyalkyl acrylates, cyanoalkyl acrylates, acrylamides or substituted acrylamides, or from moderately polar monomers such as N-vinyl pyrrolidone, acrylonitrile, vinyl chloride or diallyl phthalate. The strongly polar monomer preferably comprises up to about 25%, more preferably up to about 15%, of the polymerizable monomer composition. The moderately polar monomer preferably comprises up to about 30%, more preferably from about 5% to about 30% of the polymerizable monomer composition.

The pressure-sensitive adhesive matrix of the invention also contains initiator to aid in polymerization of the monomers. Suitable initiators include thermally-activated initiators such as azo compounds, hydroperoxides, peroxides, and the like, and photoinitiators such as the benzoin ethers, substituted benzoin ethers such as benzoin methyl ether or benzoin isopropyl ether, substituted acetophenones such as 2,2-diethoxy-acetophenone, and 2,2-dimethoxy-2-phenyl-acetophenone, substituted alpha-ketols such as 2-methyl-2-hydroxypropiophenone, aromatic sulphonyl chlorides such as 2-naphthalene sulphonyl chloride, and photoactive oximes such as 1-phenyl-1,1-propanedione-2-(O-ethoxycarbonyl) oxime. Generally, the initiator is present in an amount of from about 0.01 part to about 3.0 parts based on 100 parts monomer weight.

Where superior cohesive strengths are desired, the pressure-sensitive adhesive matrix may also be cross-linked. Preferred crosslinking agents for the acrylic pressure-sensitive adhesive matrix are multiacrylates such as 1,6-hexanediol diacrylate as well as those disclosed in U.S. Patent No. 4,379,201 (Heilmann et al.), incorporated herein by reference. Other types of crosslinking agents are also useful, e.g., any of those taught in U.S. Patents 4,330,590 (Vesley), and 4,329,384 (Vesley et al.), both of which are incorporated by reference. Each of the crosslinking agents is useful in the range of from about 0.01% to about 1% of the total weight of the monomers.

Another preferred class of pressure-sensitive adhesives are siloxane pressure-sensitive adhesives such as poly(dimethylsiloxane) pressure-sensitive adhesives, e.g., "DC 284", available from Dow Corning, and poly(diphenylsiloxane) containing pressure-sensitive adhesives, e.g., "GE 6574", available from General Electric Company.

A useful adhesive that becomes pressure-sensitive at elevated temperatures is disclosed in U.S. Pat. No. 4,880,683, (Stow), useful heat-hardenable adhesives are disclosed in U.S. Patent Nos. 3,733,755 and 3,326,741, (both Olson), all of which are incorporated herein by reference.

When an adhesive which is not tacky at room temperature is used to make the novel tape and coherent clusters or stripes of electrically conductive particles and binder have been formed in conductive particle containing pockets or perforations in the nontacky adhesive layer, the adhesive layer either can be wound up with a liner or wound upon itself without a liner for convenient storage and shipment.

Other useful materials which can be blended into the matrix include, but are not limited to, fillers, pigments, plasticizers, tackifiers, fibrous reinforcing agents, woven and nonwoven fabrics, foaming agents, antioxidants, stabilizers, fire retardants, and rheological modifiers. A preferred expanding agent is provided by expandable microspheres available as EXPANCEL™ 551DU from Nobel Industries, Sundsvall, Sweden, and having a shell consisting basically of a copolymer of vinyldiene chloride and acrylonitrile, which shell encapsulates a blowing agent (liquid isobutane) under pressure.

In one preferred embodiment, the adhesive may be a foam or foam like adhesive. This adhesive may be created by the addition of blowing agents, or by frothing air or other gases into the adhesive which is then cured with such gases creating voids. A foam like tape may also be created by the addition of microspherical fillers, either glass or polymeric. When desired, these fillers must be chosen such that they do not interfere with the electrical properties desired.

Methods of making tapes of the invention include various coating techniques. For example, a low adhesive carrier web may be mechanically punched to form perforations. A slurry of the electrically conductive particles and binder, if any, is then coated onto the face, and a knife scrapes the face clean, leaving slurry only in the perforations. Binder, if present, is then cured in an oven, and a dispersion or solution of adhesive is then knife-coated or Meyer bar coated onto the carrier web. This is then cured by the means appropriate to the individual adhesive system, e.g., thermally or by exposure to moisture or radiation.

Another method of making such a tape is to first coat and cure the adhesive onto the carrier web. Laser perforation is then performed through the web and the adhesive layer. The slurry containing the conductive particles is then applied along with the requisite heat and pressure required to force the particles into the perforations.

Another method of making an electrically conductive adhesive tape is to form perforations (e.g., using a laser) that extend completely through a flexible low-adhesion substrate such as polyethylene film. Then after bonding that substrate to a flexible web, each of the perforations is filled with a slurry of electrically conductive particles and binder, after which the slurry is dried to leave clusters. Onto the exposed face of the substrate is applied an adhesive layer which adheres strongly to the clusters but not to the substrate. Removal of the flexible web and substrate transfers the clusters to the adhesive layer, leaving an electrically conductive adhesive layer. When the clusters are smaller than the thickness of the adhesive layer, the adhesive should soften and flow in order to flow laterally under heat and pressure applied in making the interconnection.

When the clusters are equal in size to the thickness of the adhesive layer and are electrically conductive, the adhesive can be pressure-sensitive, because electrical connections can be made as soon as the adhesive bonds two electrically conductive devices together.

When the clusters are larger than the thickness of the adhesive layer, the clusters should be compressible or collapse and need not be electrically conductive until doing so.

## Description of the Drawing

In the drawing, each figure of which is schematic,

FIG. 1 is a cross section through an electrically conductive adhesive tape of the invention;

FIG. 2 is a cross section through an assembly of pair of electrical devices wherein the electrically conductive adhesive tape of FIG. 1 interconnects conductive elements;

FIG. 3 is a plan view of apparatus that can be used to make the electrically conductive adhesive tape of FIG.

FIG. 4 is a cross section through an electrically conductive adhesive tape of the invention;

FIG. 5 is a cross section through an assembly of a pair of electrical devices wherein the electrically conductive adhesive tape of FIG. 4 interconnects conductive elements;

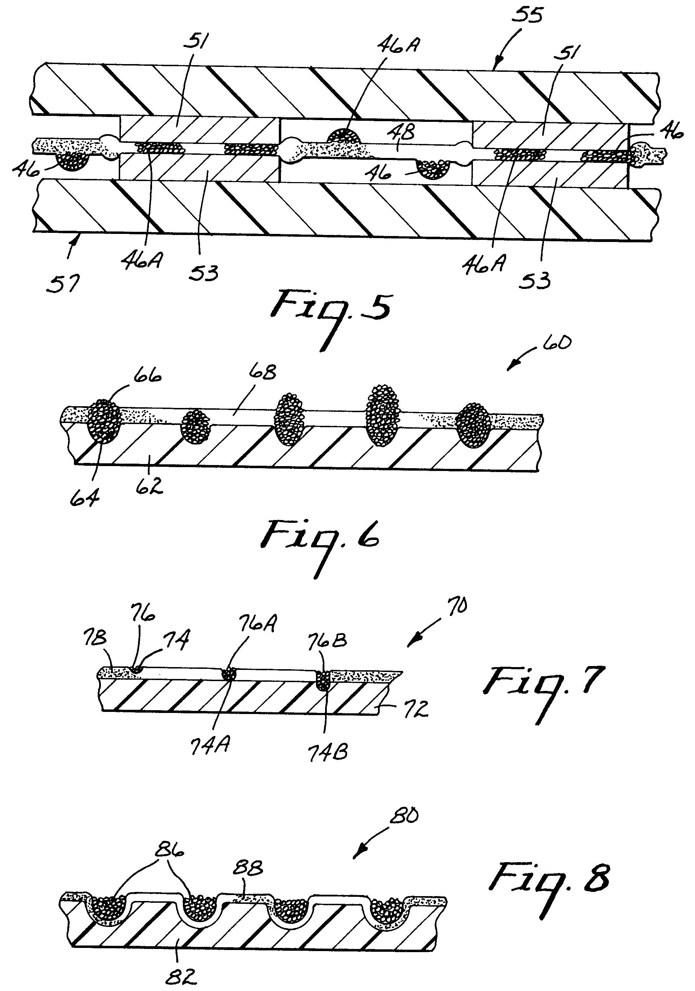

Each of FIGS. 6-10 is a cross section through an electrically conductive adhesive tape of the invention; and

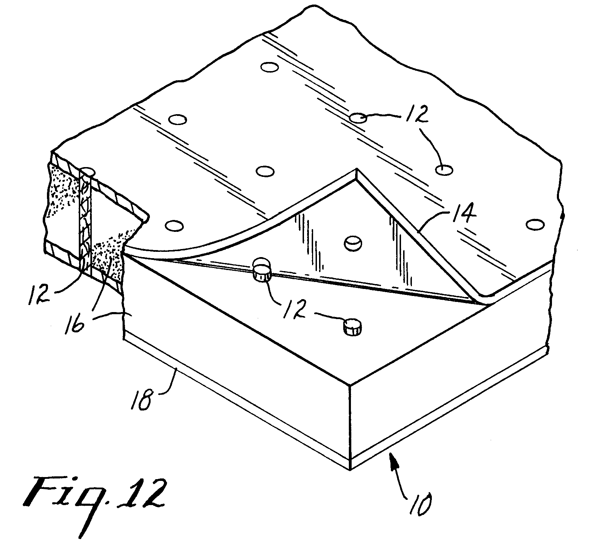

FIG. 11 is a perspective view of an electrically conductive adhesive tape of the invention.

FIG. 12 is a pictorial view of an electrically conductive adhesive tape of the invention.

## Description of the Preferred Embodiments

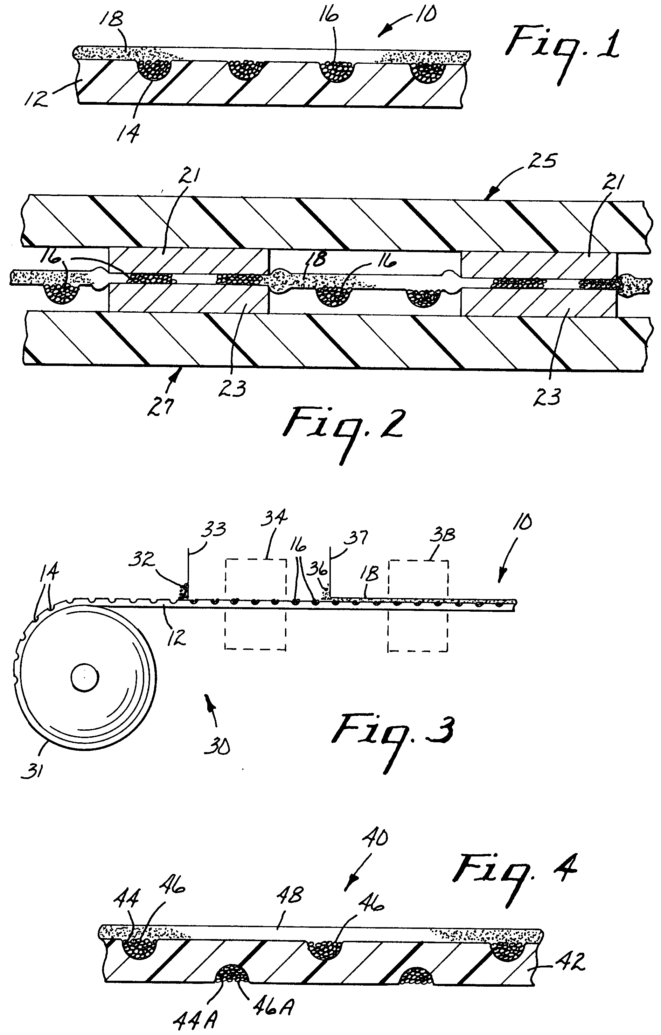

The electrically conductive adhesive tape 10 of FIG. 1 includes a flexible, disposable carrier web 12, a low-adhesion face of which has a plurality of dimples 14. Each of the dimples is filled with electrically conductive particles bound into clusters 16 by a binder (not shown). Covering the low-adhesion face and clusters is an adhesive layer 18.

FIG. 2 illustrates the use of the adhesive tape 10 of FIG. 1 to interconnect facing electrodes 21 and 23 of first and second electrical devices 25 and 27, respectively. After placing the exposed face of the adhesive layer 18 against the first electrical device 25, the carrier web 12 is removed, and the second electrical device 27 is laid against the newly exposed face of the adhesive layer. Sufficient pressure is applied to force the clusters 16 through the adhesive layer into contact with the electrodes 21 of the first electrical device 25, thus adhesively bonding the electrical devices 25 and 27 together while electrically interconnecting each facing pair of electrodes 21 and 23.

By making the adhesive layer 18 continuous and void-free between each pair of electrodes 21 and 23, the adhesive seals both the electrode arrays and the electrically conductive particles against moisture and other elements.

The tape-making apparatus 30 of FIG. 3 employs a flexible carrier web 12 having a low-adhesion face which, after being embossed to form a plurality of dimples 14, was wound into a roll 31. A slurry 32 of electrically conductive particles and binder is coated onto the low-adhesion face, and a knife 33 scrapes the low-adhesion face clean, leaving the slurry substantially only in the dimples. After curing the binder in an oven 34 to bind the particles into clusters 16, a dispersion or solution of adhesive 36 is coated with a knife 37 over the low-adhesion face and clusters. This is dried in a second oven 38 to provide the adhesive layer 18 of the tape 10 of FiG. 1.

FIG. 4 shows a second electrically conductive adhesive tape 40 which includes a flexible, disposable carrier web 42, both faces of which are low-adhesion. Formed in one face are a plurality of dimples 44 and, in the other face, dimples 44A that are offset from the dimples 44. Each of the dimples 44 and 44A is filled with electrically conductive particles that are bound into clusters 46 and 46A, respectively, by a binder (not shown). Covering the clusters 46 is an adhesive layer 48. When the adhesive tape 40 is wound upon itself into a roll and later unwound, the clusters 46A on the exposed face of the carrier web are transferred to the adhesive layer 48.

FIG. 5 shows the use of the adhesive layer 48 after being unwound and stripped from the carrier web 42 to interconnect facing electrodes 51 and 53 of a pair of electrical devices 55 and 57, respectively. While the exposed face of the adhesive layer 48 is lying on the electrical device 55, sufficient heat and pressure is applied to allow those clusters 46A that contact the electrodes 51 to be pressed into the softened adhesive. The carrier web 42 is then removed to expose the other face of the adhesive layer against which the other electrical device 57 is laid. Sufficient heat and pressure are then applied to force the clusters 46 into the adhesive and to compress the clusters 46 and 46A while allowing some of the adhesive to flow laterally into spaces between the electrodes 51 and 53. The lateral flow of the adhesive results in a higher particle-to-adhesive ratio between facing electrodes than in spaces lateral to the electrodes.

In FIG. 6, an electrically conductive adhesive tape 60 of the invention includes a flexible carrier web 62, a low-adhesion face of which is formed with a plurality of dimples 64. The tape 60 can be made by filling each of the dimples with a slurry of electrically conductive particles plus a binder and an expanding agent, expanding the slurry to form low-density clusters 66 that may or may not be electrically conductive, and then applying a layer of adhesive 68.

Alternatively, the layer of adhesive 68 can be applied before expanding the slurry. After laying the exposed face of the adhesive layer against one of a pair of electrical devices that have matching arrays of electrodes and then peeling off the carrier web, the other of the electrical devices is laid against the newly exposed adhesive surface while applying pressure. The pressure collapses each of the clusters that is located between facing electrodes until each cluster becomes electrically conductive, if it was not already electrically conductive.

To make the electrically conductive adhesive tape 70 of FIG. 7, a nontacky heat-activable adhesive layer 78 has been applied to a smooth low-adhesion face of a carrier web 72. The surface of the adhesive layer has been embossed with a plurality of dimples, three of which are shown. one dimple 74 extends part way into the adhesive, a second 74A extends completely through the adhesive layer and to the surface of the underlying carrier web, and a third 74B extends through the adhesive layer and into the underlying carrier web. (Preferably, all dimples are the same size, but three sizes are shown to illustrate suitable sizes.) Each of the dimples 74, 74A and 74B has been filled with a slurry of electrically conductive particles and a binder that has been dried to form clusters 76, 76A and 76B, respectively. Upon being separated from the carrier web, the cluster-bearing adhesive layer can be used to interconnect conductive elements.

The electrically conductive adhesive tape 80 of FIG. 8 has a carrier web 82 having a smooth low-adhesion face that has been embossed with a plurality of dimples. over this has been applied a relatively thin, nontacky adhesive layer 88 to leave the dimples, each of which has been filled with a slurry of electrically conductive particles 86. Alternatively, the illustrated dimples could have been formed after applying the adhesive layer.

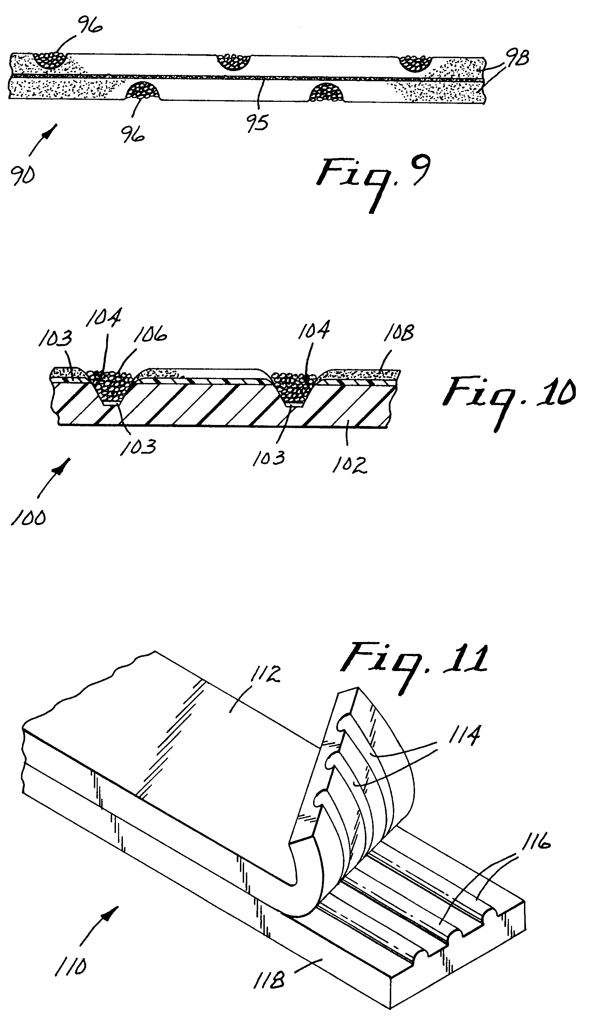

The electrically conductive adhesive tape 90 of FIG. 9 consists of a nontacky adhesive layer 98, each face of which is formed with a plurality of the dimples, each of which has been filled with a cluster 96 of electrically conductive particles and binder. At the center of the adhesive layer is a reinforcing scrim 95 through which the particles can pass. when the adhesive tape 90 is squeezed between two electrically conductive surfaces having raised electrodes, the clusters are forced through the scrim to electrically interconnect facing electrodes.

To make the electrically conductive adhesive tape 100 of FIG. 10, a carrier web 102 has been coated with a thin silicone layer 103 and then embossed to form dimples 104. Each of the dimples has been filled with a slurry of electrically conductive particles including a binder that has been dried to form clusters 106. Then, the cluster-bearing face of the carrier web has been dusted with an adhesive powder that has adhered to the silicone layer 103 and not to the clusters 106, and the powder has been fused to form an adhesive layer 108 that has an opening at each cluster. When the exposed face of the adhesive layer 108 is laid on a substantially flat surface of an electrical device and then heated and pressed against that surface, the clusters 106 contact the surface without intervening adhesive, thus ensuring good electrical contact. Then the carrier web 102 is stripped off to expose the other face of the adhesive layer 108, and a second electrical device is adhered to that exposed face.

In FIG. 11, an electrically.conductive adhesive tape 110 of the invention has a flexible carrier web 112, a low-adhesion face of which is formed with a plurality of parallel grooves 114, each extending the length of the tape. Each of the grooves has been filled with a slurry of electrically conductive particles and binder that has dried to leave an electrically conductive elongated cluster or stripe 116. over this has been applied an adhesive layer 118 to which the elongated clusters are being transferred by stripping off the carrier web 112.

The stripes of a piece of cluster-bearing adhesive layer 118 can be used to provide electrical connections between two arrays of electrodes that cannot be superimposed

Shown in Figure 12 is an electrically conductive adhesive web 10 having a carrier web 18 and a cover sheet 14. The conductive columns 12 were made by filling perforations in the carrier web 18 adhesive 16 and cover sheet 14 with a slurry of conductive particulate. The positions and shape of conductive columns 12 may be rectangles, triangles, ellipses and combinations thereof and may have any of a variety of patterns including those that may require indexing when connecting spaced terminals or electrodes. At the time of use, the cover sheet 14 is removed to expose adhesive 16 and one end of the conductive columns 12.

The functions of the cover sheet are to prevent collapse of the conductive columns when the tape is wrapped in a roll and to protect adhesive 16 from possible contamination resulting from transfer of the material used to fill conductive columns 12. During the filling of conductive columns 12, some of the binder and/or conductive particulate may be left on either the carrier web or cover sheet (depending on which side or sides is coated). When cover sheet 14 is not required it may be omitted from the construction. Processing options that could eliminate the need for a cover sheet in the final construction are to 1) clean carrier web 18 after coating to fill the conductive columns 12 and 2) coat cover sheet 14 and then remove it prior to wrapping the tape in a roll.

Likewise, some conductive columns 12 may not require the protection from collapse provided by cover sheet 14. In application of adhesive 16 to a substrate, conductive columns 12 typically contact the substrate first. When a binder is used, the amount and type (along with the conductive particulate) influences the properties of the conductive column. To this extent, the conductive columns may be designed with great latitude without the disadvantage of drastically reducing the adhesiveness of the tape or forming clumps that could short adjacent electrodes. Binders may be selected to 1) permit collapse of that portion of conductive columns 12 protruding above adhesive 16, 2) give resiliency to conductive columns 12, or 3) be an adhesive and add to the adhesive bond of adhesive 16. Large volume fractions of conductive particulate may be used in conductive columns 12 to enhance conductivity, which is the only desired location for the conductive particulate, while at the same time conserving on the total amount of conductive particulate used. This is in contrast to the prior art use of a random mixture of conductive particulate in an adhesive. For the case of a transfer tape or die cut from a transfer tape, carrier web 18 is also removed from adhesive 16 so it may be applied to a second substrate. Again, conductive columns 12 normally contact the substrate prior to adhesive 16. Adhesive 16 may be any number of adhesives including PSA, PSA foams, heat hardenable adhesives, heat hardenable PSA (U.S. Patent Nos. 3,753,755 and 3,326,741, (both by Olson and included herein by reference), hot tackifying adhesives and combinations thereof.

## Examples

### Example 1

A roll of "VHB" foam transfer tape, Scotch™ 4945, available from Minnesota Mining and Manufacturing Company, hereinafter 3M, which measured 15 cm wide and 1 mm in thickness was laminated to a second release liner of silicone-coated 50μm thick poly(ethylene terephthalate) (PET). A laser was then used to perforate 0.5 mm diameter holes through both the first and second release liners and the adhesive. The perforations were in a square lattice array on 0.6 cm centers. A slurry was made with nickel powder, available as INCO Type 123 nickel powder from International Nickel Company, having a Fisher subsieve size of 3-7 μm, an apparent density of 1.8-2.7 gm/cc and a specific surface area of 0.34-0.44 $m^2$/gm. 19 g of the nickel powder was mixed with 4 gm of a vehicle consisting of 25 percent Kraton™ 1650, available from Shell, in toluene. The slurry was then flooded onto the first release liner and wiped with a doctor blade so as to force the slurry into the perforations. When either the first or the second release liner was subsequently removed, and viewed with a light microscope, it was observed that columns of slurry protruded above the adhesive to a height approximately equal to the thickness of the respective release liner. A section of the transfer adhesive was used to bond two 1.5 mm thick and 2.54 cm wide strips of aluminum alloy (6063 T6) together so as to form an overlap joint of 3.2 cm. In this section, were 7 perforations, all of which had been filled with the slurry. The resistance between the two stripes of aluminum was about 30 Ω.

A current of 0.4 amps was then passed through the adhesive of this example without difficulty. When 1 amp was passed through the bond, the resistance of the bond became that of an open circuit.

### Example 2

A 5 cm roll of aerospace epoxy transfer tape, available as AF-126 from 3M was laminated to a kraft paper liner, each side of which was coated with polyethylene, and the side to be used toward the adhesive was also coated with a low-adhesion top coating. Removal of either release liner left conductive posts protruding from the adhesive surface. Two strips of copper 2.5 cm in width, 0.8 mm in thickness and 10 cm in length were positioned with a section of the adhesive between them to form a 1.3 cm lap; the section of adhesive had six conductive posts. A weight of 325 gm was placed so as to compress the lap joint while it was heated to 127°C for 40 minutes. After cooling to room temperature, the resistance of the adhesive bond was 6.6 milliohms and the two strips of copper were strongly bonded. Ten amps of current were passed through the bond without failure. The sample was tested in lap shear at a cross heat rate of 0.025 cm/min. At a shear stress of 7 MPa, the sample slipped in the grips of the holder and the test was discontinued.

### Example 3

A mechanically perforated Scotchcal™ sheet, available from 3M, was used for this example. This sheet construction consists of a 50μm polyvinylchloride film coated with 25μm of an acrylic pressure-sensitive adhesive, and a 0.18 mm release liner which consisted of a kraft paper core, each side of which is coated with polyethylene, and the side to be used toward the adhesive is also coated with a low-adhesion top coating. The entire sheet had perforations having 0.5 mm diameters in a square lattice array on 0.7 cm centers.

The perforations were filled with a conductive slurry containing ten parts of a vehicle containing 10 percent Kraton™ 1650 in toluene, nine parts INCO 255 nickel powder and one part toluene. INCO type 255 nickel powder has a Fisher subsieve size of 2.2-2.8μm, an apparent density of 0.5-0.65 gm/cc and a specific surface area of 0.68 m²/gm.

The surface was flooded with the slurry and then wiped with a squeegee. The release liner was removed and the sample bonded to an aluminum sheet. A volt-ohm meter was used to confirm electrical conductivity from the surface of the Scotchcal™ to the aluminum sheet.

Examples 4 and 4C

A reworkable adhesive transfer tape containing 25 microns of thermoset-based adhesive on a transparent release liner, available as 5300 from 3M Company, was perforated with a carbon dioxide laser. The holes were cone shaped throughout the adhesive thickness, having a diameter of about 0.2 mm at the adhesive release liner interface and a diameter of about 0.35 mm at the adhesive surface. The perforations were on 1 mm centers in parallel rows 0.5 mm apart.

The slurry described in Example 3 was coated into these holes from the release liner side of the transfer tape. The conductive transfer adhesive was then transferred to a 3.5 mm sheet of aluminum by first contacting the aluminum with the adhesive, heating, cooling and then removing the release liner. An aluminum disk having a diameter of 1.2 cm and a thickness of 3 mm with a shaft 8 mm in length by 3mm in diameter was placed in an oven at 200°C and then bonded to the aluminum sheet by means of the conductive adhesive. The resistance between the disk and the sheet was less than 0.1 ohm. A current of 10 amps was passed through this bond without failure. For comparative purposes, Example 4C was made using neat adhesive and the resistance was that of an open circuit.

Example 5

The shear strength of the conductive transfer adhesive of Example 4 was compared to the neat adhesive of Example 4C. Lap shear values from aluminum substrates were measured according to ASTM D 1002. The lap shear values were 3.0 MPa for the conductive adhesive (Example 4), and 2.4 MPa for the neat adhesive (Example 4C). This difference in lap shear is not statistically significant. These data therefore demonstrate that the tapes of the invention can incorporate electrically conductive particles without significant reduction in lap shear.

Example 6

A piece of the transfer tape of Example 4 about 2.5 cm in length and about 0.4 cm in width was used to adhesively bond a flexible circuit to a printed circuit board. The tape had three parallel rows of conductive columns extending over its length. The flexible circuit was 74 μm polyimide (Kapton™, available from DuPont) with an array of 17 parallel copper traces 34 microns thick at a pitch of 1 mm. The width and the distance between the copper traces was 0.5 mm. The printed circuit board had an identical array of copper traces. The resistance of each bond between corresponding electrodes was less than 0.1 ohm and no adjacent electrodes shorted out.

Example 7

This example reports the preparation of an adhesive tape bearing clusters of 2 ⁻ m nickel powder and a binder. The same heat-activatable adhesive was used both for the adhesive layer and the binder, namely a solution of the adhesive of No. 5300 adhesive film from 3M Co.

A 0.18 mm silicone-coated polypropylene release film was embossed to have 16 dimples per cm in a square lattice array. Each dimple was an inverted truncated cone having diameters of 0.18 mm at the surface and 0.10 mm at its depth of 0.064 mm. The embossed face of the release film was flooded with a slurry of 32 parts of the nickel powder, 8 parts of the binder, and sufficient tetrahydrofuran (THF) to adjust the viscosity to about 500 cps. After wiping with a doctor blade, the slurry in the dimples was allowed to dry at room temperature to form clusters. The embossed face of the release film was then coated with a solution of the same binder in THF which dried to a curable heat-activatable adhesive having a thickness of about 50 μm, thus producing a first electrically conductive adhesive tape of the invention.

The tape was cut into strips that were used to interconnect two circuit boards of 0.5 mm leads, 1 mm in

pitch and 34 μm in height. The adhesive layer was removed from the release film and placed on one set of leads. The matching set was aligned by eye and clamped to apply pressure across the bond area. The clamp and boards were oven heated to 120°C for 15 min. The oven was shut off and allowed to cool overnight. when tested for electrical continuity with a volt-ohm meter, all conductor pairs were successfully connected, and there were no shorts between adjacent conductors.

Example 8

A second electrically conductive adhesive tape of the invention was made using a first mixture of 20 g of phenolic prepolymer of 75% solids with ethylene glycol ether solvent, 10 g of expandable microspheres (EXPANCEL 551DU) and 10 g of 90 parts isopropanol/10 parts water. Two parts of the first mixture were combined with a second mixture of 4 parts of 15 μm nickel powder (nickel flake from Novamet, Wyckoff, NJ) and one part of isopropanol to provide a slurry that was coated onto a piece of the embossed release film used in Example 7. After wiping with a doctor blade, the deposited slurry was dried for 5 minutes at room temperature. Then the release film was placed in an oven at 120°C for ten minutes to expand the slurry to form low density clusters that protruded from the dimples. Over the low density clusters was knife coated a solution of acrylic pressure-sensitive adhesive of 48% solids in ethyl acetate, toluene and isopropanol. After air drying for 5 min., this was placed in an oven at 120°C for 3 min. The coating was then exposed to UV A black light (30 watt, 46 cm) delivering approximately 320 mJ/cm$^2$ min for 3 min., thus producing said second tape.

A piece of the second tape was placed on cleaned (polished with 600 grit coated abrasive sheeting and cleaned with MEK) contacts of a printed circuit board. Then after removing the release film, a matching board was aligned by eye and pressed into place by hand pressure. A volt-ohm meter was used to confirm electrical continuity and absence of shorting.

Example 9

A third electrically conductive adhesive tape of the invention was made as in Example 8 except that the silicone-coated release film was embossed to have 26 dimples per cm. A pressure-sensitive adhesive copolymer of isooctyl acrylate and acrylic acid (90:10, 25% solids in ethyl acetate and heptane) was coated over the expanded clumps and air dried for 1 hr. When a piece of this tape was used to join test boards as in Example 8, similar results of electrical continuity and absence of shorting were observed.

Example 10

The heat-activatable adhesive of Example 7 was coated onto a biaxially oriented polypropylene film and dried to a thickness of 50 μm. The adhesive layer was thermally embossed to have 33 dimples per cm in a square lattice array. The shape of each dimple was a truncated cone with approximate diameters at top and bottom of 75 μm and 50 μm, respectively. The depth of each dimple was nearly through the thickness of the adhesive film. The dimples were filled with the conductive slurry of Example 1 to form clusters.

To test the utility of this tape for adhesively bonding two members while electrically interconnecting individual electrodes, a piece of the tape was used to bond a flexible circuit to a printed circuit board. The flexible circuit was 75 μm polyimide ("Kapton" from E.I. duPont) with an array of 17 parallel copper traces (34 μm thick) at,a pitch of 1 mm. The width of the copper traces and the spacing between them were both 0.5 mm. The printed circuit board had an identical array of copper traces.

First, the exposed adhesive face was laid on the printed circuit and bonded thereto at 980 kPa and 100°C for 5 sec. The width of the bond was 1.5 mm. The carrier was removed from the adhesive, and the flexible circuit positioned so that the traces were in register with those on the circuit board. The flexible circuit was then bonded to the circuit board at 1960 kPa and 180°C for 20 sec.

Interconnection resistances were measured using a two-wire method. Each resistance measurement included the resistance of the copper traces on both the printed circuit board and the flexible circuit as well as the resistance of the two interconnections. The resistances of the copper traces varied from trace to trace and from board to board, and ranged in value from 180 to 250 mg. Total resistances cross each of 17 pairs of adhesive connections were measured and are presented in Table 1.

A similar experiment was carried out but with embossed Comparative Adhesive Layer A that did not contain any conductive particles, electrical connection being accomplished because the heat and pressure were sufficient to result in direct contact between terminals of the printed circuit test boards and copper traces of the flexible circuit. Comparison test data in Table I shows that the tape of Example 4 provided electrical connections of lower resistance than did Comparative Adhesive Layer A.

## Table I

### (Resistance in ohms)

| Channel No. | Adhesive Layer of Example 10 | Comparative Adhesive Layer A |
|:---:|:---:|:---:|
| 1 | 0.094 | 0.097 |
| 2 | 0.092 | 0.098 |
| 3 | 0.093 | 0.104 |
| 4 | 0.091 | 0.124 |
| 5 | 0.090 | 0.110 |
| 6 | 0.090 | 0.256 |
| 7 | 0.088 | 0.230 |
| 8 | 0.085 | 0.097 |
| 9 | 0.085 | 0.093 |
| 10 | 0.084 | 0.092 |
| 11 | 0.086 | 0.094 |
| 12 | 0.087 | 0.112 |
| 13 | 0.088 | 0.102 |
| 14 | 0.099 | 0.096 |
| 15 | 0.090 | 0.094 |
| 16 | 0.090 | 0.098 |
| 17 | 0.091 | 0.094 |

Example 11

To the polyethylene face of a duplex film of 37 $\mu$m low-density polyethylene film and 75 $\mu$m biaxially oriented poly(ethylene terephalate) film was applied a silicone coating. The silicone-bearing face of the duplex film was embossed to have 98 dimples per cm arranged in a square lattice array to provide 9604 dimples/cm$^2$. Each dimple was a truncated pyramid having a square bottom (about 37 $\mu$m on a side), a square top (about 47 $\mu$m on a side), and a depth of about 37 $\mu$m.

Each of these dimples was filled with a slurry consisting of nickel powder, "Kraton" elastomer (G-1650 from Shell) and cyclohexane. The nickel powder was INCO Type 123 from International Nickel, which has an average Fisher subsieve size of 3 to 7 $\mu$m. The slurry had been made by dissolving 5 parts of the "Kraton" elastomer in cyclohexane and then adding 95 parts of the nickel powder. Hand spreads were made by flooding the embossed face with the slurry and using a rubber doctor blade to wipe the surface clean of slurry except in the dimples. After allowing the solvent to evolve at room temperature, the embossed face was overcoated with the adhesive of Example 7 which was allowed to dry at room temperature to a thickness of 42 $\mu$m.

To measure the interconnect stability and uniformity of the resulting tape, bonds were made between 1) a flexible circuit and a rigid printed circuit board and 2) the flexible circuit and ITO (indium tin oxide) coated glass. The flexible circuit was KAPTON™ polyimide, available from E.I. Dupont, having an array of 17 parallel copper traces 34 $\mu$m thick, 0.2 mm wide, and 0.4 mm center to center. Each trace was gold plated. The printed circuit board had an identical array. The ITO coating had a resistance of 20 ohms per square.

The exposed adhesive face of a strip of the tape of Example 11 was bonded to the flexible circuit using a hot plate at 120°C while pushing on the unembossed side of the carrier film with a cotton swab. After cooling, the carrier was removed to expose the adhesive layer by which the flexible circuit was bonded either to the ITO coated glass or to the printed circuit board using the bonding conditions of Example 10.

After cooling to room temperature, the resistances were measured with a four-wire probe arrangement such that 15 of the 17 connections were measurable. These resistances are recorded in Table II for each of the 15 connections between the flexible circuit and the circuit board and between the flexible circuit and the ITO coated glass. The two bonded samples were then placed in a chamber and thermal cycled between minus 55°C and 125°C over a period of about 5 hours. After 66 hours and again after 256 hours, the samples were removed from the thermal cycle chamber and allowed to rest at room temperature for 1 hour before measuring the resistances of the connections, as reported in Table II. These tests show that the tape of Example 11 provided low and uniform resistance connections, and that these resistances remained low even after thermal cycling.

## Table II

### (Resistance in ohms)

| | Flex. Circuit/Circuit Bd.<br>Thermal Cycled<br>(Hrs.) | | | Flex. Circuit/Glass<br>Thermal Cycled<br>(Hrs.) | | |
|---|---|---|---|---|---|---|
| Channel<br>No. | As Bonded | 66 | 256 | As Bonded | 66 | 256 |
| 1 | 0.247 | 0.251 | 0.251 | 0.448 | 0.754 | 1.86 |
| 2 | 0.246 | 0.246 | 0.246 | 0.435 | 0.883 | 2.11 |
| 3 | 0.245 | 0.250 | 0.251 | 0.445 | 0.859 | 2.34 |
| 4 | 0.241 | 0.243 | 0.243 | 0.432 | 0.799 | 2.39 |
| 5 | 0.241 | 0.241 | 0.240 | 0.429 | 0.851 | 2.08 |
| 6 | 0.242 | 0.240 | 0.240 | 0.449 | 0.811 | 2.47 |
| 7 | 0.236 | 0.236 | 0.236 | 0.417 | 0.844 | 2.73 |
| 8 | 0.235 | 0.236 | 0.235 | 0.456 | 0.796 | 2.28 |
| 9 | 0.235 | 0.236 | 0.237 | 0.433 | 0.786 | 1.98 |
| 10 | 0.239 | 0.238 | 0.239 | 0.422 | 0.783 | 2.08 |
| 11 | 0.241 | 0.243 | 0.244 | 0.450 | 0.791 | 1.91 |
| 12 | 0.242 | 0.243 | 0.244 | 0.428 | 0.844 | 2.07 |
| 13 | 0.246 | 0.249 | 0.249 | 0.441 | 0.769 | 2.20 |
| 14 | 0.248 | 0.249 | 0.248 | 0.456 | 1.028 | 2.87 |
| 15 | 0.249 | 0.248 | 0.248 | 0.452 | 0.791 | 2.00 |

Comparative Examples 7A-11A

Particle-free adhesive tapes were made by coating each of the adhesives of Example 7-11 onto an unembossed silicone-coated polypropylene release film to a thickness of about 50 μm.

Lap Shear Values from aluminum (measured under ASTM D1002) of each of the adhesive tapes of Examples 7-11 and Comparative Examples 7A-11A are reported in Table III.

## Table III

| Example | Lap Shear Value in MPa | Comparative Example | Lap Shear Value in MPa |
|---|---|---|---|
| 7 | 3.4 | 7A | 5.8 |
| 8 | 0.67 | 8A | 0.51 |
| 9 | 0.82 | 9A | 1.5 |
| 10 | 6.1 | 10A | 4.2 |
| 11 | 2.4 | 11A | 4.1 |

The differences in Lap Shear Values from aluminum between the tapes of Examples 7-12 and 7A-11A, respectively, are within experimental error. These data show that tapes of the invention can incorporate electrically conductive particles without significant reduction in Lap Shear Value.

Electrically conductive adhesive tape of the invention can be employed for a variety of uses where electrical and/or thermal connections are required, e.g., for attaching a semiconductor die or chip to an electrically and thermally conductive substrate. An adhesive layer of the novel tape that contains electrically conductive clusters or stripes can be used to join steel panels to form the housing of an electrical appliance, thus serving both as a structural adhesive and to provide electrically conductive paths by which the appliance can be grounded for user safety.

## Claims

1. An electrically conductive adhesive tape comprising a carrier having a low-adhesion face bearing thereon an adhesive layer having substantially uniform thickness and a Lap Shear Value from aluminum of at least 0.2 MPa, said tape being formed having a plurality of conductive particle containing sections, said sections being selected from perforations and pockets, each of said sections containing a plurality of electrically conductive particles in contact with the adhesive layer which is otherwise substantially free from electrically conductive material.

2. An electrically conductive adhesive tape as defined in claim 1 wherein the maximum breadth of each conductive particle containing section is about 0.1 mm.

3. An electrically conductive adhesive tape as defined in claim 1 wherein each of said conductive particle containing sections are of substantially equal size and are in a predetermined array.

4. An electrically conductive adhesive tape as defined in claim 1 wherein said conductive particle containing sections are in a square or hexagonal array and have a center-to-center spacing of no more than 0.1 mm.

5. An electrically conductive adhesive tape as defined in claim 1 wherein said adhesive layer is a pressure-sensitive adhesive.

6. An electrically conductive adhesive tape as defined in claim 1 wherein said conductive particles are selected from the group consisting of nickel, silver, copper, gold, aluminum, tin and alloys thereof.

7. An electrically conductive adhesive tape as defined in claim 1 wherein said conductive particle containing sections further contain an organic binder selected from the group consisting of thermoplastic resins, thermoset resins and mixtures thereof.

8. An electrically conductive adhesive having the ability to carry from about 5 to about 10 amps per $cm^2$.

9. An electrically conductive adhesive foam tape with a thickness of at least 0.5 mm.

10. An electrically conductive adhesive tape according to claim 1 containing both pockets and perforations.

13

Fig. 1

Fig. 2

Fig. 3

Fig. 4

14

55

51                                46A                    51

46A                    48                    46

46                                            46

57                                            53

46A    53                57    46A    53

**Fig. 5**

60

66          68

64    62

**Fig. 6**

76          76A        76B        70

78    76    74                    72

74A        74B

**Fig. 7**

80

86          88

82

**Fig. 8**

96

98

96

95

90

*Fig. 9*

103  104  106                104      108

103

103        102

100

*Fig. 10*

*Fig. 11*

112

114

116

110

118

16

Fig.12

**European Patent Office**

# EUROPEAN SEARCH REPORT

Application Number

EP 92 30 3071

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | EP-A-0 429 269 (MINNESOTA MINING)<br>* the whole document * | 1-6 | H01B1/22<br>C09J9/02 |
| X | FR-A-2 357 040 (JAPAN SYNTHETIC RUBBER)<br>* the whole document * | 1,3-6,10 | |
| A | EP-A-0 330 452 (MINNESOTA MINING)<br>* claims 1-10 * | 1 | |
| A | US-A-4 548 862 (R.B.HARTMAN)<br>* claims 1-19 * | 1 | |
| A | US-A-4 546 037 (T.W.KING)<br>* claims 1-13 * | 1 | |

TECHNICAL FIELDS
SEARCHED (Int. Cl.5)

H01B
C09J

The present search report has been drawn up for all claims

| Place of search | Date of completion of the search | Examiner |
|---|---|---|
| THE HAGUE | 16 JULY 1992 | DROUOT M.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)